# EUROPÄISCHE PATENTSCHRIFT

(11) **EP 3 733 316 B1**
(45) Veröffentlichungstag und Bekanntmachung des Hinweises auf die Patenterteilung: **24.08.2022**
(21) Anmeldenummer: 19171673.7
(22) Anmeldetag: 29.04.2019
(51) Int. Cl.: B08B 3/04, B08B 3/10, H05K 3/26

(54) **WASCH- UND/ODER REINIGUNGSGERÄT**
WASHING AND/OR CLEANING APPARATUS
APPAREIL DE LAVAGE ET / OU DE NETTOYAGE

(43) Veröffentlichungstag der Anmeldung: 04.11.2020
(73) Patentinhaber: Wiwox GmbH Surface Systems, 40699 Erkrath (DE)
(72) Erfinder: Axel, Hallensleben, 40474 Düsseldorf (DE)
(74) Vertreter: Brinkmann & Partner

(56) Entgegenhaltungen:
- DE-B3-102015 116 196
- GB-A- 191 004 282
- US-A- 2 857 923

## Beschreibung

Die Erfindung betrifft ein Wasch- und/oder Reinigungsgerät für industrielle Bauteile oder Werkstücke, insbesondere Leiterplatten, mit einem einen Wasch- und/oder Reinigungsraum bereitstellenden Bottich und einem der Bauteil- und/oder Werkstückaufnahme dienenden Korb, wobei der Korb in Relation zum Bottich in Höhenrichtung verfahrbar und um eine Korbhochachse verdrehbar ausgebildet ist.

Ein gattungsgemäßes Wasch- und/oder Reinigungsgerät ist aus der DE 10 2015 116 196 B3 bekannt. Des Weiteren ist aus der US 2,857,923 A eine Waschmaschine für industrielle Bauteile oder Werkstücke bekannt, die über einen Bottich und einen Korb zur Aufnahme der zu waschenden Bauteile oder Werkstücke verfügt. Der Korb ist höhenverfahrbar ausgebildet und kann in den Bottich hinab bzw. aus diesem heraus verfahren werden. Aus der GB 04282 A ist darüber hinaus eine Hebe- und Senkeinrichtung für einen Korb bekannt, mittels welcher der Korb in einen Bottich absenkbar ist. Dabei ist die Hebe- und Senkeinrichtung neben einem Traggestell des Bottichs angeordnet.

Die aus der DE 10 2015 116 196 B3 vorbekannte Wasch- und/oder Reinigungsanlage verfügt über einen einen Wasch- und/oder Reinigungsraum bereitstellenden Innenbottich sowie über einen den Innenbottich unter Belassung eines Spaltraums aufnehmenden Außenbottich. Es ist des Weiteren ein der Bauteil- und/oder Werkstückaufnahme dienender Korb vorgesehen, der höhenverfahrbar und in den Innenbottich absenkbar ausgebildet ist. Zudem ist der Korb um eine Korbhochachse relativ zum Innenbottich verdrehbar und um eine horizontal verlaufende Schwenkachse verschwenkbar ausgebildet.

Gemäß dieser vorbekannten Konstruktion kann der im Reinigungsfall in den Innenbottich abgesenkte Korb in eine Rotationsbewegung um seine Hochachse verbracht werden. Infolge einer solchen Verdrehbewegung wird auch die im Innenbottich befindliche Spülflüssigkeit in eine Verdrehbewegung versetzt, was zu einer gezielt ausgebildeten Strudelbewegung führt. Diese Strudelbewegung durchgreift auch das Korbinnere, wodurch es zu einer Reinigung von vom Korb beherbergten Bauteilen und/oder Werkstücken kommt. Dabei wird das Reinigungsergebnis dadurch noch verbessert, dass der Korb um eine horizontal verlaufende Schwenkachse verschwenkbar ausgebildet ist, was es gestattet, die Rotationsbewegung des Korbes um die Korbhochachse durch eine Pendelbewegung um eine horizontal verlaufende Schwenkachse zu überlagern. Im Ergebnis dieser Bewegungsüberlagerung stellen sich verstärkt Querströmungen innerhalb der Spülflüssigkeit ein, womit die Zugänglichkeit der Spülflüssigkeit zu an sich schwer zugänglichen Bauteil- und/oder Werkstückgeometrien deutlich verbessert ist.

Obgleich sich die aus der DE 10 2015 116 196 B3 vorbekannte Wasch- und/oder Reinigungsanlage im alltäglichen Praxiseinsatz bewährt hat, besteht Verbesserungsbedarf, insbesondere mit Blick auf einen vereinfachten Aufbau. Es ist deshalb die **Aufgabe** der Erfindung, die aus der DE 10 2015 116 196 B3 vorbekannte Konstruktion dahingehend weiterzuentwickeln, dass bei einer gleichzeitigen Vereinfachung des Aufbaus eine vereinfachte Handhabung ermöglicht ist.

Zur **Lösung** dieser Aufgabe wird mit der Erfindung ein Wasch- und/oder Reinigungsgerät der eingangs genannten Art vorgeschlagen, das sich auszeichnet durch ein Traggestell, das einen den Bottich aufnehmenden Tragrahmen aufweist, durch einen am Traggestell angeordneten Vertikalständer und durch einen am Vertikalständer angeordneten Schlitten, wobei der Schlitten entlang des Vertikalständers in Höhenrichtung verfahrbar ist, wodurch der Korb in den Bottich absenkbar oder aus diesem herausfahrbar ist, und wobei der Schlitten eine Koppeleinheit zur verdrehbaren Anordnung des Korbes bereitstellt, so dass eine Verdrehung des Korbs um eine Korbhochachse realisierbar ist.

Das erfindungsgemäße Wasch- und/oder Reinigungsgerät verfügt über ein Traggestell. Dieses nimmt im endmontierten Zustand den Bottich auf. In der Grundfläche ist das Traggestell bevorzugter Weise quadratisch ausgebildet, so dass eine insgesamt vergleichsweise große Aufstellfläche realisiert ist, was die Standfestigkeit des Wasch- und/oder Reinigungsgeräts insgesamt verbessert.

Gemäß einer bevorzugten Ausführungsform verfügt das Traggestell über zwei in Höhenrichtung übereinander angeordnete Tragrahmen, die jeweils quadratisch ausgebildet sind. Zur beabstandeten Anordnung der beiden Tragrahmen dienen Tragstützen, wobei zumindest vier solcher Tragstützen vorgesehen sind. Für eine weitere Aussteifung des Traggestells können zusätzliche Versteifungsstreben vorgesehen sein, die die Tragrahmen und/oder die Tragstützen miteinander verbinden.

Erfindungsgemäß zeichnet sich das Wasch- und/oder Reinigungsgerät des Weiteren durch einen Vertikalständer aus. Dieser Vertikalständer ist am Traggestell angeordnet und dient der verfahrbaren Aufnahme eines Schlittens. Im bestimmungsgemäßen Verwendungsfall kann der Schlitten entlang des Vertikalständers in Höhenrichtung verfahren, so dass der Vertikalständer dem Schlitten nach Art einer Schienenanordnung als Führungseinheit dient.

Der Schlitten stellt erfindungsgemäß eine Koppeleinheit zur verdrehbaren Anordnung des Korbes bereit. Insofern dient die Koppeleinheit dazu, eine Verdrehung des Korbes um eine Korbhochachse zu realisieren, so dass der Korb in Relation zum Schlitten und damit auch zu dem vom Traggestell aufgenommenen Bottich in eine Rotationsbewegung um eine Korbhochachse versetzt werden kann.

Die erfindungsgemäße Konstruktion ist denkbar einfach, zugleich aber robust und standsicher ausgebildet. Dies erbringt den Vorteil, das erfindungsgemäße Wasch- und/oder Reinigungsgerät auch als Stand-alone-Gerät nutzen zu können. Im Bedarfsfall können auch eine Mehrzahl von erfindungsgemäßen Wasch- und/oder Reinigungsgeräte zu einer gemeinsamen Anlage miteinander kombiniert werden. Damit bietet die erfindungsgemäße Konstruktion im Unterschied zur vorbekannten Konstruktion nach der DE 10 2015 116 196 B3 die wahlweise Möglichkeit einer Stand-alone-Nutzung einerseits sowie einer Anlagennutzung durch Gerätekombination andererseits.

Die erfindungsgemäße Konstruktion vereinfacht auch die Handhabung im bestimmungsgemäßen Betriebsfall. Denn je erfindungsgemäßem Wasch- und/oder Reinigungsgerät sind ein Bottich und ein damit in Wirkverbindung stehender Schlitten vorgesehen. Eine für mehrere Bottiche gleichsam genutzte Korbverdreh- und/oder Verfahreinrichtung ist nicht vorgesehen. Insofern gestattet der nach der Erfindung am Traggestell angeordnete Vertikalständer auch nur eine Schlittenbewegung in Längsrichtung des Vertikalständers, das heißt in Höhenrichtung des erfindungsgemäßen Wasch- und/oder Reinigungsgeräts. Dabei dient eine Schlittenbewegung dazu, einen von der Koppeleinheit des schlittengetragenen Korbs in den Bottich abzusenken oder aus diesem heraus zu verfahren. Eine Überlagerung dieser Verfahrbewegung mit einer Verfahrbewegung quer zur Höhenerstreckung des Wasch- und/oder Reinigungsgeräts ist nicht möglich, wodurch sich insgesamt eine Vereinfachung ergibt. Es sind insbesondere Kollisionsfahrten zum Zwecke des Bottichwechsels vermieden.

Im bestimmungsgemäßen Reinigungsfall kann der Korb ausschließlich eine Verdrehbewegung um eine Korbhochachse vollführen. Eine Verschwenkbewegung des Korbes um eine horizontal verlaufende Schwenkachse ist in Abkehr zur Konstruktion nach der DE 10 2015 116 196 B3 nicht möglich. Auch hierdurch ergibt sich eine insgesamt vereinfachte Korbbewegung im bestimmungsgemäßen Betriebsfall. Dabei wird mit der erfindungsgemäßen Ausgestaltung bewusst auf die Möglichkeit einer Verschwenkbewegung um eine horizontal verlaufende Achse verzichtet, denn Untersuchungen der Anmelderin haben ergeben, dass je nach geometrischer Ausgestaltung zu waschender und/oder zu reinigender Bauteile und/oder Werkstücke ein hinreichendes Reinigungsergebnis bereits dadurch erzielt werden kann, dass der Korb im Reinigungsfall ausschließlich um eine Korbhochachse verdreht. Insbesondere bei zu reinigenden Leiterplatten ist eine zusätzliche Verschwenkbewegung des Korbes um eine horizontal verlaufende Schwenkachse nicht erforderlich. Insoweit gestattet die erfindungsgemäße Konstruktion auch keine Bewegungsüberlagerung von Verdrehbewegung einerseits und Verschwenkbewegung andererseits, was eine vereinfachte Handhabung ohne Qualitätseinbuße beim Reinigungsergebnis erbringt.

Im bestimmungsgemäßen Verwendungsfall werden eine Verfahrbewegung des Korbes in Höhenrichtung und eine Verdrehbewegung desselben um eine Korbhochachse voneinander bevorzugter Weise unabhängig hintereinander durchgeführt. In einer möglichen Ausgangssituation ist der Schlitten in Höhenrichtung in seine obere Position verfahren. In dieser Schlittenposition ist der vom Schlitten unter Zwischenschaltung der Koppeleinheit getragene Korb verwenderseitig zugänglich. Dies ermöglicht eine Bestückung desselben mit zu reinigenden Bauteilen und/oder Werkstücken. Sobald dies geschehen ist, verfährt der Schlitten in Höhenrichtung nach unten in eine untere Stellung. In dieser Stellung des Schlittens ist der Korb samt davon aufgenommener Bauteile und/oder Werkstücke in den vom Bottich bereitgestellten Reinigungsraum verbracht. Alsdann ist zwecks Durchführung des eigentlichen Reinigungsvorgangs der Korb in eine Rotationsbewegung zu versetzen, und zwar um eine in Längsrichtung des Vertikalständers verlaufende Korbhochachse. Die Korbrotation erfolgt für eine vorgebbare Zeitdauer. Sobald die Korbrotation beendet ist, verfährt der Schlitten samt Korb in Höhenrichtung zurück in die ursprüngliche Ausgangsposition, so dass eine verwenderseitige Entnahme der nun gereinigten Bauteile und/oder Werkstücke aus dem Korb stattfinden kann.

Gemäß einer bevorzugten Ausführungsform ist vorgesehen, dass der Bottich zumindest abschnittsweise kreiszylindrisch ausgebildet ist und koppelelementseitig eine kreisförmig ausgebildete Beschickungsöffnung aufweist. Durch diese Beschickungsöffnung wird im Reinigungsfall der mit zu waschenden und/oder zu reinigenden Bauteilen und/oder Werkstücke bestückte Korb geführt. In Abkehr zum Stand der Technik ist eine ovale Ausgestaltung der Beschickungsöffnung nicht erforderlich, da der Korb im bestimmungsgemäßen Reinigungsfall ausschließlich eine rotatorische Bewegung um eine Korbhochachse, nicht aber eine Schwenkbewegung um eine horizontal verlaufende Schwenkachse vollführt.

Die zumindest Abschnittsweise kreiszylindrische Ausgestaltung des Bottichs sorgt zudem in vorteilhafter Weise dafür, dass sich über den Bottichquerschnitt vergleichmäßigte Strömungsbewegungen innerhalb der vom Bottich aufgenommenen Spülflüssigkeit einstellen, wenn der Korb im Reinigungsfall bestimmungsgemäß rotiert. Dies führt zu einer vergleichmäßigten Spülflüssigkeitsbeaufschlagung der vom Korb beherbergten Werkstücke und/oder Bauteile, was zu einem einheitlichen Reinigungsergebnis beiträgt.

Gemäß einer bevorzugten Ausführungsform ist der Bottich nach unten konisch zulaufend ausgebildet. Dies erbringt im Wesentlichen zwei Vorteile. Zum einen wird im bestimmungsgemäßen Betriebsfall durch die konische Ausgestaltung die Strudelausbildung in der Spülflüssigkeit unterstützt. Zum anderen ist durch den konischen Zulauf ein Bottichboden geschaffen, der ein Absetzen von Schmutzpartikeln und/oder dergleichen Verunreinigungen ermöglicht, indem eine an den Bottich strömungstechnisch angeschlossene Leitung für ein Abführen von nicht mehr benötigter Spülflüssigkeit in einen gewissem Abstand oberhalb des Bottichbodens in den Bottich einmündet. Dabei stellt die konische Ausgestaltung des Bottichs eine Minimierung des sich durch diesen Leitungsanschluss einstellenden Todraums dar, was dazu beiträgt, die für einen Wasch- und/oder Reinigungsvorgang benötigte Menge an Spülflüssigkeit zu minimieren.

Gemäß einer bevorzugten Ausführungsform ist vorgesehen, dass die Koppeleinheit einen mit der Beschickungsöffnung zusammenwirkenden Verschlussdeckel aufweist. Gemäß dieser bevorzugten Ausführungsform kommt ein Verschlussdeckel zum Einsatz, der im bestimmungsgemäßen Reinigungsfall die Beschickungsöffnung verschließt. Auf diese Weise ist sichergestellt, dass nicht ungewollt Spülflüssigkeit aus dem Bottich heraus in die den Bottich umgebende Atmosphäre gelangen kann. Darüber hinaus erbringt der Verschlussdeckel den Vorteil, das sich im bestimmungsgemäßen Betriebsfall infolge einer Korbrotation im Reinigungsraum einstellende Vakuum halten zu können. Zu diesem Zweck ist es gemäß einer bevorzugten Ausführungsform auch vorgesehen, dass der Verschlussdeckel bottichseitig eine umlaufende Dichtung, vorzugsweise eine umlaufende Ballondichtung aufweist. Diese Dichtung sorgt im bestimmungsgemäßen Verwendungsfall für ein dichtes Anliegen des Verschlussdeckels am Bottich, so dass es zur Unterdruckausbildung innerhalb des Bottichs kommen kann.

Der Verschlussdeckel ist von der zur verdrehbaren Anordnung des Korbes vorgesehenen Koppeleinheit bereitgestellt. Dies erbringt den konstruktiven Vorteil, dass es infolge einer bestimmungsgemäßen Verfahrbewegung des Schlittens zwecks Einfahren des Korbes in den Reinigungsraum zu einem automatischen Verschluss der Beschickungsöffnung kommt. Denn Korb und Verschlussdeckel werden gleichsam bei einer Schlittenbewegung verfahren. Bei einem Verfahren des Korbes in Höhenrichtung nach oben kommt es in umgekehrter Weise zu einem gleichzeitigen Verfahren auch des Verschlussdeckels, wodurch die Beschickungsöffnung freigegeben wird.

Gemäß einer bevorzugten Ausführungsform ist vorgesehen, dass der Verschlussdeckel eine Durchgangsöffnung aufweist, durch die hindurch eine verdrehbar am Verschlussdeckel angeordnete Welle geführt ist, die bottichseitig mit einem Verbindungsmittel zur vorzugsweise auswechselbaren Anordnung des Korbes an der Welle und anderendseitig mit einem in Wirkverbindung mit einer Motor-Getriebe-Einheit stehenden Antriebsflansch ausgerüstet ist.

Demnach verfügt der Verschlussdeckel über eine Durchgangsöffnung, durch die hindurch eine Welle geführt ist, die verdrehbar am Verschlussdeckel angeordnet ist. Zu diesem Zweck ist in die Durchgangsöffnung eine entsprechende Wellenlagerung eingesetzt. Im bestimmungsgemäßen Betriebsfall kann die Welle relativ zum Verschlussdeckel verdreht werden.

Bottichseitig ist die Welle mit einem Verbindungsmittel ausgerüstet, das der Anordnung des Korbes an der Welle dient. Dabei erlaubt das Verbindungsmittel bevorzugter Weise eine auswechselbare Anordnung des Korbes an der Welle. Anderendseitig ist die Welle mit einem Antriebsflansch ausgerüstet. Dieser steht in Wirkverbindung mit einer Motor-Getriebe-Einheit, beispielsweise mittels einer Ketten- oder Keilriemenanordnung oder einem vergleichbaren Kraftübertragungsmittel.

Im bestimmungsgemäßen Verwendungsfall ist das Kraftübertragungsmittel von der Motor-Getriebe-Einheit angetrieben, wobei diese Motor-Getriebe-Einheit bevorzugterweise mit dem Schlitten verfahrbar am Schlitten angeordnet ist. Im Antriebsfall erfolgt eine Verdrehbewegung der Welle durch die Motor-Getriebe-Einheit, was zu einer Rotation des an der Welle angeordneten Korbes führt.

Gemäß einer bevorzugten Ausführungsform ist vorgesehen, dass die Motor-Getriebe-Einheit der Koppeleinheit gegenüberliegend am Schlitten angeordnet ist. Es ist so eine Gewichtsgleichverteilung bei entsprechender Gewichtsdimensionierung von Koppeleinheit und Motor-Getriebe-Einheit gegeben. In diesem Fall hängt der Schlitten quasi im Gleichgewicht am Vertikalständer, so dass Kippdrehmomente des Schlittens im Vergleich zum Vertikalständer auf ein Minimum begrenzt sind. Auch diese konstruktive Maßnahme sorgt für eine besondere Stabilität, da insbesondere unerwünschte Kippmomente des Verschlussdeckels entgegen des Uhrzeigersinns in Richtung des Bottichs vermieden sind. Insbesondere für ein vakuumdichtes Anliegen des Verschlussdeckels am Bottich zum Verschluss der Beschickungsöffnung ist dies von Vorteil.

Bei dem Verbindungsmittel zur vorzugsweise auswechselbaren Anordnung des Korbes an der Welle handelt es sich vorzugsweise um eine Dornenaufnahme. Diese sorgt dafür, dass der im bestimmungsgemäßen Verwendungsfall an der Welle angeordnete Korb durch einfaches Verspannen an der Welle befestigt beziehungsweise von dieser gelöst werden kann. Dies ermöglicht eine schnelle auswechselbare Anordnung eines Korbes an der Welle.

Es ist gemäß einer bevorzugten Ausführungsform vorgesehen, dass sich der Schlitten unter Zwischenordnung einer Spindeleinrichtung am Vertikalständer abstützt, wobei die Spindeleinrichtung eine stationär am Vertikalständer oder am Traggestell angeordnete Motor-Getriebe-Einheit aufweist. Die Spindeleinrichtung erlaubt eine hinreichend präzise Schlittenzustellbewegung, und dies bei gleichzeitig robustem Aufbau. Dabei trägt die Spindel der Spindeleinrichtung den gesamten Schlitten samt daran angeordneter Koppeleinheit und Korb. Zur Abstützung gegenüber dem Vertikalständer ist der Schlitten bevorzugter Weise mit Rollen ausgerüstet, so dass eine Reibungsminimierung zwischen Schlitten und Vertikalständer gegeben ist.

Gemäß einer bevorzugten Ausführungsform ist vorgesehen, dass der Bottich zumindest abschnittsweise doppelwandig ausgebildet ist und ein Innenteil und ein Außenteil aufweist, wobei das Innenteil unter Belassung eines Spaltraums innerhalb des Außenteils angeordnet ist.

Gemäß einer bevorzugten Ausführungsform ist der vom Traggestell aufgenommene Bottich als einfacher Bottich, das heißt einwandig ausgebildet. Anstelle eines solchen einfachen Bottichs kann aber auch gemäß einer zweiten Alternative vorgesehen sein, den Bottich doppelwandig auszugestalten. Es sind dann ein Außenbottich und ein davon ausgenommener Innenbottich vorgesehen.

Die Außenbottich-Innenbottich-Konstruktion hat den Vorteil, dass der Pegelstand an Spülflüssigkeit innerhalb des Innenbottichs automatisch auf ein Maximum eingestellt ist. Denn im bestimmungsgemäßen Betriebsfall findet eine Befüllung des Innenbottichs mit Spülflüssigkeit statt, bis dieser überläuft. Die überlaufende Spülflüssigkeit gelangt in den Spaltraum zwischen Innenbottich und Außenbottich und kann alsdann abgeführt und im Bedarfsfall dem Innenbottich im Umwälzbetrieb wieder zugeführt werden. Auf diese Weise wird ein stets gleicher und maximaler Pegelstand der Spülflüssigkeit innerhalb des Innenbottichs sichergestellt.

Um ein Überlaufen von Spülflüssigkeit aus dem Außenbottich zu vermeiden, ist der Außenbottich mit seiner oberen Randkante höher ausgebildet als der Innenbottich. Dieses Überlaufprinzip kann auch dazu genutzt werden, im Reinigungsfall auftretende Schäume oder hochschwimmende Ablagerungen gezielt abströmen zu lassen.

Anstelle eines Außenbottichs kann gemäß einer Alternative auch ein umlaufender Ringkanal vorgesehen sein. Dieser Ringkanal wirkt nach Art einer Rinne und ist unterhalb eines den Innenbottich oberseitig begrenzenden Kragens angeordnet. Sobald es zu einer Überfüllung des Innenbottichs kommt, strömt die überschüssige Spülflüssigkeit über den oberseitigen Kragen des Innenbottichs und gelangt in den umlaufenden Ringkanal. Der Ringkanal verfügt unterseitig über mehrere Abströmungsöffnungen, über welche die überschüssige Spülflüssigkeit abgeführt werden kann.

Im bestimmungsgemäßen Verwendungsfall herrscht im Bottich ein leichter Unterdruck. Dies macht ein Überführen des den Bottich verschließenden Deckels in die Offenstellung gegebenenfalls schwergängig. Die Abführöffnungen im umlaufenden Ringkanal dienen im Öffnungsfall bevorzugterweise dazu, einen Druckausgleich im Bottich zu bewirken, was ein Abheben des Verschlussdeckels vereinfacht.

Gemäß einer besonders bevorzugten Ausführungsform ist ein separat zum Bottich ausgebildetes Silo zur Bevorratung von Wasch- und/oder Reinigungsflüssigkeit vorgesehen. Der Bottich und das Silo stehen mittels einer ersten Leitung in strömungstechnischer Verbindung, wobei die Leitung mit Bezug auf die Höhenrichtung des Bottichs in einen unteren Bereich des Bottichs und mit Bezug auf die Höhenrichtung des Silos in einen unteren Bereich des Silos einmündet. Dabei ist in diese erste Leitung bevorzugter Weise ein Sperrventil integriert, mittels dem die erste Leitung im Bedarfsfall sperrbar ist.

Das Silo dient der Bevorratung von Wasch- und/oder Reinigungsflüssigkeit. Es ist vor Beginn eines bestimmungsgemäßen Reinigungs- und/oder Waschvorgangs mit Spülflüssigkeit bis zu einem bestimmten Pegelstand gefüllt. Bei geöffnetem Sperrventil kann über die erste Leitung Spülflüssigkeit aus dem Silo in den Bottich überströmen, und zwar ohne Einsatz einer Pumpe. Dabei findet ein Überströmen von Spülflüssigkeit aus dem Silo in den Bottich so lange statt, bis in beiden Behältnissen ein gleicher Pegelstand erreicht ist. Das Sperrventil der ersten Leitung wird alsdann geschlossen. Sobald im bestimmungsgemäßen Verwendungsfall eine Verdrehbewegung des Korbes stattfindet, entsteht eine Wirbelströmung innerhalb des Bottichs, die dafür Sorge trägt, dass die Spülflüssigkeit innenseitig des Bottichs an den Bottichwänden nach oben gedrückt wird.

Hierdurch entsteht im Bottich ein Unterdruck, so dass bei dann wieder geöffnetem Sperrventil Spülflüssigkeit aus dem Silo in den Bottich nachgesogen wird. Es findet insofern eine pumpenfreie Überführung von Spülflüssigkeit aus dem Silo in den Bottich statt. Bevor dann beispielsweise wegen eines Drehrichtungswechsels die Rotationsbewegung des Korbes unterbrochen wird, erfolgt durch eine erneute Betätigung des Sperrventils ein Sperren der ersten Leitung. Damit ist die zuvor in den Bottich überführte Spülflüssigkeit im Bottich gefangen und kann trotz Unterbrechung der Rotationsbewegung des Korbes nicht zurück in das Silo strömen. Es kann so ein mehrfacher Drehrichtungswechsel des Korbes durchgeführt werden, ohne dass es zu einem Verlust von Spülflüssigkeit innerhalb des Bottichs kommt.

Das Silo ist ebenso wie der Bottich bevorzugterweise nach unten konisch zulaufend ausgebildet. Die den Bottich mit dem Silo verbindende erste Leitung greift behälterseitig sowie siloseitig bevorzugterweise im Bereich der jeweiligen Konusschräge an, so dass etwaige sich im Konus ansammelnde Sedimente nicht mit überführt werden. Ein Abschöpfen solcher Sedimente ist bevorzugterweise über eine zusätzliche Abführleitung möglich, die am tiefsten Punkt des Silos angeordnet ist.

Sobald ein Spülvorgang beendet ist, wird die Rotationsbewegung des Korbes eingestellt und das Sperrventil in der ersten Leitung wird wieder geöffnet. Die Spülflüssigkeit kann infolgedessen aus dem Bottich zurück in das Silo strömen, bis wieder Pegelgleichstand besteht. Die dann noch im Bottich befindliche Restmenge ist mittels einer Pumpe abzuführen und dem Silo vorzugsweise von oben aufzugeben. Es ist deshalb gemäß einer bevorzugten Ausführungsform vorgesehen, dass der Bottich und das Silo mittels einer zweiten Leitung in strömungstechnischer Verbindung stehen, wobei die zweite Leitung mit Bezug auf die Höhenstreckung des Bottichs in einen unteren Bereich des Bottichs und mit Bezug auf die Höhenstreckung des Silos in einen oberen Bereich des Silos einmündet. In diese zweite Leitung ist zwecks Spülflüssigkeitsüberführung eine Pumpe integriert.

Innerhalb des Silos befindet sich vorzugsweise ein Filter, durch den die von oben aufgegebene Spülflüssigkeit zunächst einmal strömt, so dass Schmutzpartikel und/oder dergleichen Verunreinigungen abgefangen werden können. Nach einer gewissen Zeit der Ruhe innerhalb des Silos setzen sich nicht abgefilterte Sedimente an der untersten Stelle des nach unten konisch zulaufenden Silos ab. Diese können über die dafür vorgesehene Abführleitung abgeführt werden, so dass sie im bestimmungsgemäßen Betriebsfall nicht zurück in den Bottich gelangen. Dies auch deshalb nicht, weil die erste Leitung, das heißt die Überführungsleitung zwischen Silo und Bottich an der konischen Schräge des Silos angeordnet ist, sodass im Spülflüssigkeitsüberführungsfall etwaige Sedimente nicht mitgerissen werden.

Nach einer gewissen Beruhigung der Spülflüssigkeit innerhalb des Silos können sich auch weniger dichte Flüssigkeitsbestandteile an der Oberfläche der Spülflüssigkeit absetzen, die im bestimmungsgemäßen Betriebsfall beim Überführen von Spülflüssigkeit in den Bottich nicht mit überführt werden sollen. Es ist deshalb vorgesehen, zu keinem Zeitpunkt eine vollständige Entleerung des Silos herbeizuführen.

Das automatische Einsaugen von Spülflüssigkeit aus dem Silo durch die Rotation des Korbes erweist sich um Unterschied zur Verwendung einer Pumpe als weniger energieaufwendig. Es gibt darüber hinaus weitere Vorteile insbesondere in Bezug auf eine Reinigung von Leiterplatten.

Grundsätzlich gilt, dass Leiterplatten nach ihrer Herstellung verschmutzt sind, weshalb es einer Reinigung bedarf. Insbesondere haftet Leiterplatten herstellungsbedingt Flusssäure an. Diese gilt es zu entfernen.

Theoretisch eignet sich für eine solche Reinigungsaufgabe am besten eine Ultraschallreinigung. Diese kann aber gerade bei Leiterplatten keine Anwendung finden, da eine Beaufschlagung der Leiterplatten mit Ultraschall zu einer Zerstörung der elektronischen Bauteile der Leiterplatten führen würde. Insofern scheidet eine Ultraschallreinigung bei Leiterplatten prinzipiell aus.

Zur Entfernung von Flusssäure kommt ein Wasser-Alkohol-Gemisch zum Einsatz. Dies deshalb, weil Wasser mit oder ohne chemische Zusätze eine zu hohe Dichte aufweist. Denn die einzelnen Komponenten einer Leiterplatte sind zum Teil derart dicht nebeneinander auf einer Trägerplatte positioniert, das eine bestimmungsgemäße Reinigung nur dadurch erreicht werden kann, dass der Kapilareffekt ausgenutzt wird. Dies bedingt aber eine gewisse niedrige Dichte des Reinigungsmittels, damit der Kapilareffekt überhaupt in entsprechender Weise eintreten kann. Aus diesem Grunde wird ein Wasser-Alkohol-Gemisch eingesetzt, das eine niedrigere Dichte als reines Wasser hat.

Das Wasser-Alkohol-Gemisch kann nur dann zu einer effektiven Reinigung der Leiterplatten beitragen, wenn es als Emulsion vorliegt, Wasser und Alkohol also nicht entmischt sind. Nach dem Stand der Technik kommen zur Einbringung der Spülflüssigkeit in den Bottich Pumpen zum Einsatz. Diese Pumpen müssen konstruktiv in der Lage sein, eine Förderung es Alkohol-Wasser-Gemisches zu bewerkstelligen, ohne dass es zu einer Entmischung von Wasser und Alkohol kommt. Diese Problematik tritt insbesondere deshalb auf, weil Pumpen systembedingt Scherwirkungen auf die zu fördernde Flüssigkeit ausüben, was zu einer Trennung von einzelnen Bestandteilen der Flüssigkeit führt. Es kommen deshalb bei gattungsgemäßen Reinigungs- und/oder Waschgeräten spezielle Pumpen zum Einsatz, die es ermöglichen, ohne eine Entmischung Emulsionen fördern zu können. Derartige Pumpen sind aber in nachteiliger Weise sehr teuer und aufwendig in der Handhabung.

Die gesamte Pumpenproblematik wird mit der bevorzugten Ausgestaltung vermieden. Denn dadurch, dass im bestimmungsgemäßen Verwendungsfall eine Rotationsbewegung des Korbes stattfindet, wird quasi ein Pumpeneffekt innerhalb des Bottichs erzeugt, der einerseits für eine Überführung von Spülflüssigkeit aus dem Silo sorgt und der andererseits dazu beiträgt, dass eine Entmischung der Wasser-Alkohol-Emulsion unterbleibt.

Um diesen Effekt noch zusätzlich zu unterstützen, kann der Korb unterseitig mit schaufelartigen Leitblechen ausgerüstet sein, was die Pumpwirkung noch erhöht. Zwar ist es aus dem Stand der Technik gemäß der DE 10 2015 116 196 B3 nicht unbekannt, den Korb mit Leitblechen auszurüsten, doch kommen die vorbekannten Leitbleche ausschließlich zum Einsatz, um je nach Drehrichtung des Korbes eine Wirbelausbildung innerhalb des Bottichs in Richtung der zentralen Drehachse zu unterstützen. Die pumpenlose Ausgestaltung ist aus der DE 10 2015 116 196 B3 nicht bekannt und somit auch nicht, schaufelartige Leitbleche am Korb anzuordnen, die technisch den durch die Verdrehbewegung des Korbes erzeugten Pumpeneffekt zusätzlich unterstützen.

Gemäß einer bevorzugten Ausführungsform ist vorgesehen, dass der Korb als Trageinheit mit auswechselbar davon ausgenommenen Magazinen zur beabstandeten Anordnung von Bauteilen und/oder Werkstücken, insbesondere Leiterplatten ausgebildet ist.

Alternativ kann auch eine Trageinheit vorgesehen sein, die eine magazinartige Anordnung von zu säubernden Bauteilen und/oder Werkstücken ermöglicht. Dabei meint "magazinartig", dass die von der Trageinheit im bestimmungsgemäßen Verwendungsfall aufgenommenen Bauteile oder Werkstücke gleich verteilt und unter jeweiliger Belassung eines Spaltraums beabstandet zueinander angeordnet sind. Die Spülflüssigkeit wird bei entsprechender Drehrichtung des Korbes von unten angesaugt, durchströmt den Korb mittig und wird alsdann nach außen durch die Spalte zwischen den einzelnen Werkstücken oder Bauteilen hindurchgedrückt. Hierdurch kommt es zu einer effektiven Reinigung. Gegenüber herkömmlichen Reinigungsanlagen, bei denen an sich bekannten Sprühdüsen zum Einsatz kommen, die zielgerichtet zu reinigende Werkstücke mit Spülflüssigkeit beaufschlagen, wird ein weitaus verbessertes Reinigungsergebnis erzielt. Darüber hinaus erlaubt die erfindungsgemäße Ausgestaltung auch eine sehr viel schnellere Reinigungsdurchführung, was ebenfalls zu einer Effektivitätssteigerung gegenüber dem Stand der Technik beiträgt.

Zu Abdichtung des Bottichs kommt eine bottichseitig am Verschlussdeckel angeordnete Ballondichtung zum Einsatz. Bei einer Überführung des Verschlussdeckels in die Verschlussstellung verfährt der spindelgetriebene Schlitten. Dabei erfolgt ein Verfahren des Schlittens soweit, bis die Dichtung nur leicht eingequetscht zwischen Verschlussdeckel und Bottichrand angeordnet ist. Dieses nur leichte Andrücken der Dichtung ist ausreichend, um in schon vorbeschriebener Weise durch eine Verdrehbewegung des Korbs einen Unterdruck innerhalb des Bottichs entstehen zu lassen. Infolge dieses Unterdrucks saugt sich der Verschlussdeckel an den Bottich an, womit die Ballondichtung noch weiter zusammengedrückt wird, was einen dichten Sitz des Verschlussdeckels am Bottich bewirkt.

Eine bevorzugte Ausführungsform ergibt sich aus der nachfolgenden Beschreibung anhand der Figuren. Dabei zeigen
- Fig. 1: in schematisch perspektivischer Darstellung ein erfindungsgemäßes Wasch- und /oder Reinigungsgerät mit einem nach oben verfahrenen Korb;
- Fig. 2: in schematisch perspektivischer Darstellung das erfindungsgemäßen Gerät nach Fig. 1 aus einer anderen Blickrichtung;
- Fig. 3: in schematischer Seitenansicht das erfindungsgemäße Gerät nach den Figuren 1 und 2;
- Fig. 4: in schematischer, geschnittener Perspektivdarstellung ein erfindungsgemäßes Wasch- und/oder Reinigungsgerät mit einem nach unten verfahrenen Korb und
- Fig. 5: in schematischer Darstellung die Wirkverbindung zwischen Bottich und Silo.

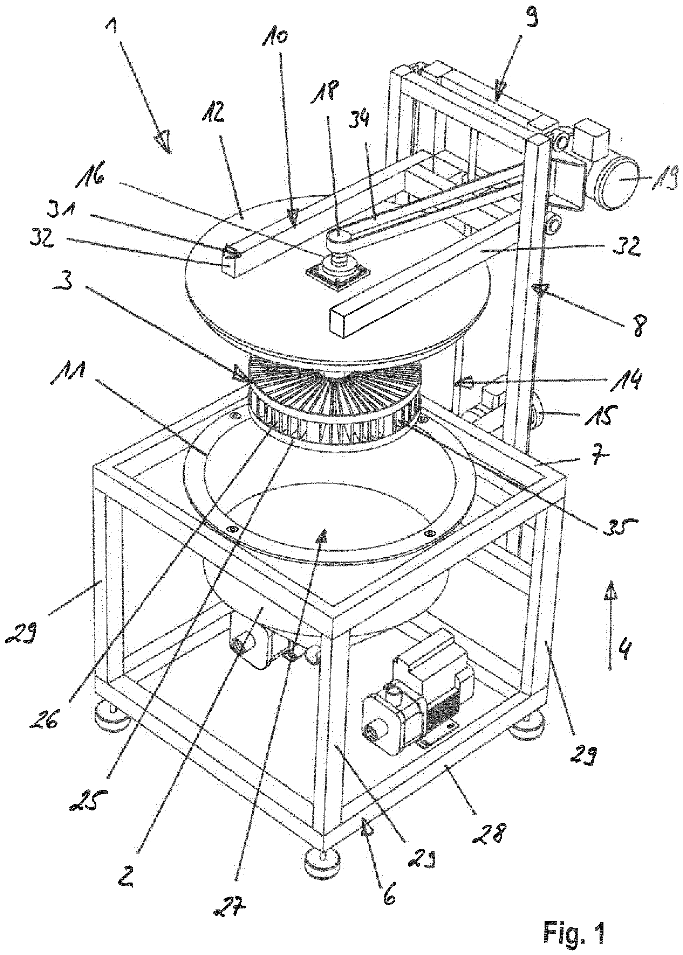

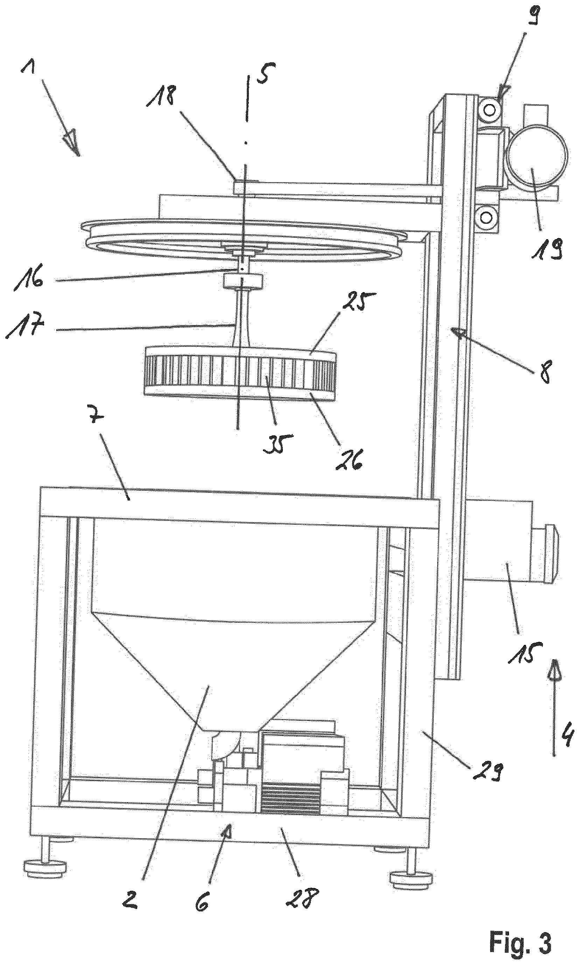

Die Figuren 1 bis 4 lassen in ihrer Zusammenschau das erfindungsgemäße Wasch- und/oder Reinigungsgerät 1 erkennen.

Das erfindungsgemäße Wasch- und/oder Reinigungsgerät 1 verfügt über ein Traggestell 6. Dieses weist einen oberen Tragrahmen 7 und einen unteren Tragrahmen 28 auf. Die Tragrahmen 7 und 28 sind jeweils quadratisch ausgebildet und unter Zwischenordnung von vier Tragstützen 29 beabstandet zueinander angeordnet. Durch die quadratische Ausgestaltung der Tragrahmen 7 und 28 ist eine vergleichsweise breite Aufstellfläche erreicht, so dass das Traggestell 6 einen insgesamt sicheren Stand hat.

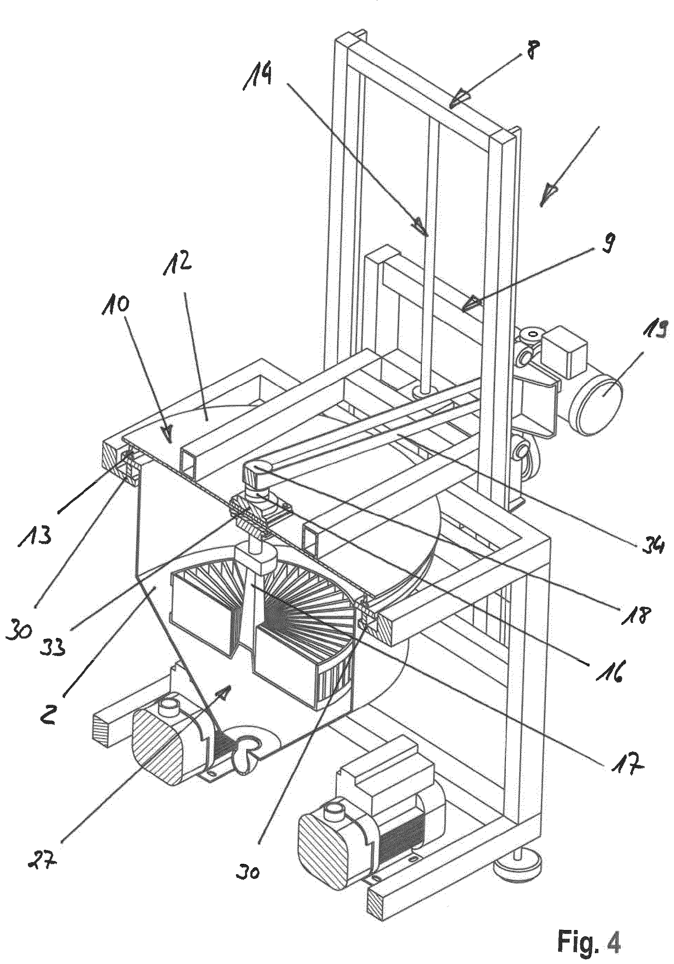

Das Traggestell 6 dient der Aufnahme eines Bottichs 2. Dieser stützt sich, wie insbesondere die Darstellung nach Fig. 4 erkennen lässt, am oberen Tragrahmen 7 ab.

Dieser weist zu diesem Zweck innenseitig Haltefortsätze 30 auf, auf denen der Bottich 2 randseitig aufliegt.

Wie insbesondere auch die Darstellung nach Fig. 4 erkennen lässt, ist der Bottich 2 tragrahmenseitig im Querschnitt kreiszylindrisch ausgebildet. Nach unten verlaufend ist der Bottich 2 konisch ausgebildet, wobei am tiefsten Punkt des Bottichs 2 eine Leitung 23 strömungstechnisch einmündet.

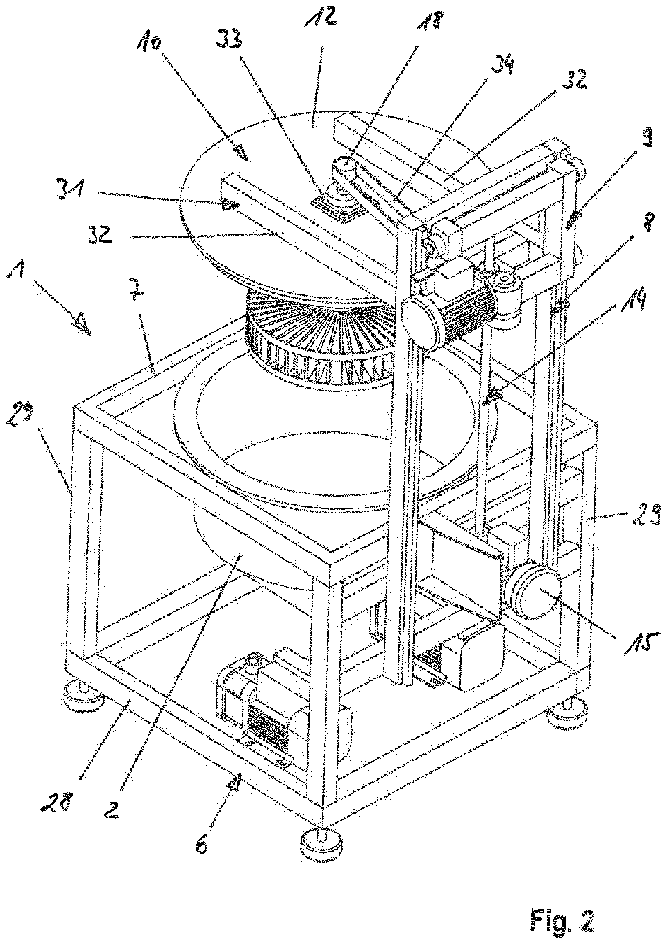

Am Traggestell 6 ist ein Vertikalständer 8 angeordnet, der sich in Höhenrichtung 4 erstreckt. Dieser Vertikalständer 8 trägt verfahrbar einen Schlitten 9, wie dies insbesondere die Darstellung nach Fig. 2 erkennen lässt. Der Schlitten 9 verfügt über Rollen, mittels derer der Schlitten 9 in Längsrichtung des Vertikalständers 8, das heißt in Höhenrichtung 4 relativ zum Vertikalständer 8 verfahren kann. Der Schlitten 9 ist unter Zwischenordnung einer Spindeleinrichtung 14 am Vertikalständer 8 angeordnet, wobei die Spindeleinrichtung 14 eine stationär am Vertikalständer 8 angeordnete Motor-Getriebe-Einheit aufweist.

Der Schlitten 9 trägt zwecks verdrehbarer Anordnung eines Korbes 3 eine Koppeleinheit 10. Im gezeigten Ausführungsbeispiel weist die Koppeleinheit 10 ein Balkengestell 31 mit zwei Balken 32 auf. Die Balken 32 des Balkengestells 31 tragen einen mit der Beschickungsöffnung 11 des Bottichs 2 zusammenwirkenden Verschlussdeckel 12. Wie insbesondere die Darstellung nach Fig. 4 erkennen lässt, ist der Verschlussdeckel 12 mittig mit einer Durchgangsöffnung ausgerüstet, durch die hindurch eine Welle 16 geführt ist. Die Welle 16 ist verdrehbar gegenüber dem Verschlussdeckel 12 angeordnet, zu welchem Zweck ein Wellenlager 33 vorgesehen ist.

Bottichseitig ist die Welle 16 mit einem Verbindungsmittel 17 ausgerüstet, das der vorzugsweise auswechselbaren Anordnung des Korbes 3 an der Welle 16 dient.

Anderendseitig ist die Welle 16 mit einem Antriebsflansch 18 ausgerüstet. Dieser steht mittels eines Keilriemens 34 in Wirkverbindung einer vom Schlitten 9 gleichfalls getragenen Motor-Getriebe-Einheit 19.

Im dargestellten Ausführungsbeispiel ist der Korb 3 als Trageinheit 25 ausgebildet, der einzelne Magazine 26 zur Aufnahme von Leiterplatten 35 bereitstellt.

Im bestimmungsgemäßen Betriebsfall kann der Schlitten 9 samt daran angeordneter Koppeleinheit 10 und davon getragenem Korb 3 in Höhenrichtung 4 sowohl nach oben als auch in gegengesetzter Richtung, das heißt nach unten verfahren. Hierzu dient die Spindeleinrichtung 14, die mit der Motor-Getriebe-Einheit 15 zusammenwirkt.

Die Figuren 1, 2 und 3 lassen den Schlitten 9 in seiner in Höhenrichtung 4 nach oben verfahrenen Position erkennen. In dieser Schlittenposition ist der Korb 3 verwenderseitig frei zugänglich, so dass eine Bestückung des Korbes 3 mit zu reinigenden Leiterplatten 35 beziehungsweise eine Entnahme von gereinigten Leiterplatten 35 aus dem Korb 3 stattfinden kann.

Fig. 4 zeigt den Schlitten 9 in seiner in Höhenrichtung 4 nach unten verfahrenen Stellung. In dieser Stellung des Schlittens 9 ist der Korb 3 in den vom Bottich 2 bereitgestellten Reinigungsraum verbracht. In dieser Schlittenstellung ist zudem die Beschickungsöffnung 11 des Bottichs 2 durch den am Bottich 2 anliegenden Verschlussdeckel 12 verschlossen. Für einen dichten Abschluss sorgt eine bottichseitig am Verschlussdeckel 12 angeordnete Ballondichtung 13.

Im bestimmungsgemäßen Reinigungsfall erfolgt eine Verdrehbewegung des Korbs 3 um die Korbhochachse 5. Zu diesem Zweck erfolgt ein Korbantrieb durch die Motor-Getriebe-Einheit 19. Diese wirkt mittels des Keilriemens 34 mit der Welle 16 zusammen, so dass im Falle einer Verdrehbewegung der Welle 16 eine Verdrehbewegung auch des Korbes 3 stattfindet.

Im bestimmungsgemäßen Verwendungsfall ist der Bottich 2 mit Spülflüssigkeit gefüllt. Nach einer Bestückung des Korbes 3 mit zu reinigenden Bauteilen, wie zum Beispiel Leiterplatten 35 wird der Schlitten 9 in die in Fig. 4 gezeigte untere Stellung verbracht. Infolgedessen taucht der Korb 3 in die im Bottich 2 befindliche Spülflüssigkeit ein. Es erfolgt alsdann eine Verdrehbewegung des Korbs 3, infolgedessen es zu einer leichten Unterdruckausbildung innerhalb des durch den Verschlussdeckel 12 dicht abgeschlossenen Bottichs 2 kommt. Die Rotationsbewegung des Korbes 3 bewirkt eine Strudelausbildung innerhalb der Spülflüssigkeit infolgedessen der Korb 3 mit Spülflüssigkeit mittig durchströmt wird, welche Spülflüssigkeit alsdann durch die zwischen den einzelnen Leiterplatten befindlichen Spalträume nach außen hindurchgedrückt wird. Hierdurch kommt es zu einer mechanischen Kraftbeaufschlagung der Leiterplatten, so dass in Kombination mit der Spülflüssigkeit eine wirkungsvolle Reinigung erreicht wird.

Die erfindungsgemäße Ausgestaltung zeichnet sich unter anderem dadurch aus, dass es zur Beschickung des Bottichs 2 mit Spülflüssigkeit keiner Pumpe bedarf. Das erfindungsgemäße Gerät 1 ist insoweit pumpenfrei ausgebildet. Dies macht die Konstruktion einfach und preisgünstig im Aufbau sowie ebenfalls auch einfach in der Handhabung.

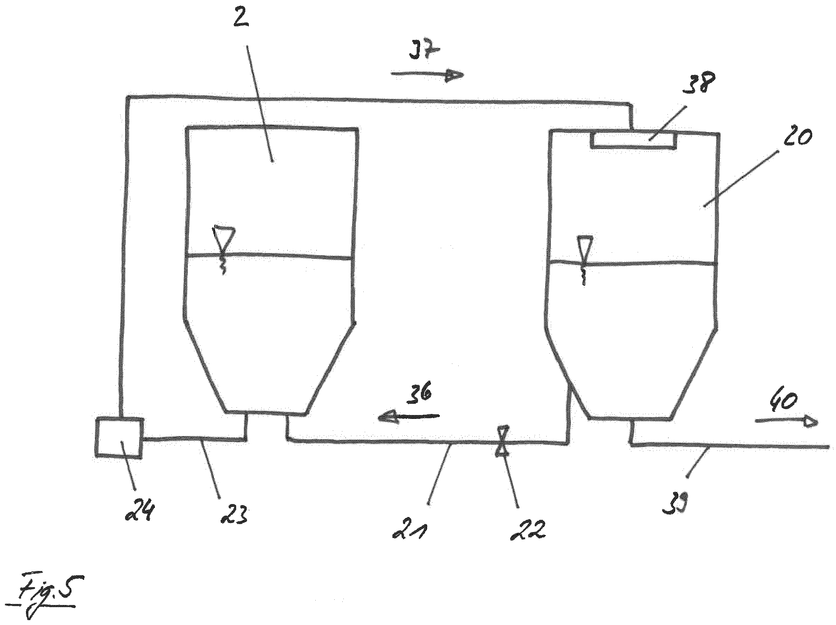

Die pumpenlose Funktion der erfindungsgemäßen Ausgestaltung ergibt sich insbesondere aus der Darstellung nach Fig. 5.

Fig. 5 lässt schematisch den Bottich 2 des erfindungsgemäßen Wasch- und/oder Reinigungsgeräts 1 erkennen. Zur Bevorratung von Spülflüssigkeit dient ein separat zum Bottich 2 ausgebildeter Silo 20. Dieser steht über eine erste Leitung 21 in strömungstechnischer Verbindung mit dem Bottich 2. In diese Leitung 21 ist ein Sperrventil 22 integriert, was im Bedarfsfall eine Absperrung dieser Leitung 21 ermöglicht.

Es ist eine zweite Leitung 23 vorgesehen, die den Bottich 2 ebenfalls mit dem Silo 20 strömungstechnisch verbindet. In diese zweite Leitung 23 ist eine Pumpe 24 integriert.

Gemäß dieser Konstruktion ist eine Verfahrensweise wie folgt möglich. Eine Befüllung des Bottichs 2 findet über das Silo 20 statt. Dabei ist das Silo vor Beginn eines Waschvorgangs mit Spülflüssigkeit bis zu einem bestimmten Pegelstand befüllt. Über die Leitung 21 kann bei geöffnetem Sperrventil 22 Spülflüssigkeit aus dem Silo 20 in den Bottich 2 überströmen, und zwar ohne Einsatz einer Pumpe. Dabei findet ein Überströmen von Spülflüssigkeit aus dem Silo 20 in den Bottich 2 solange statt, bis in beiden Behältnissen ein gleicher Pegelstand erreicht ist. Sobald dies geschehen ist, wird das Sperrventil 22 geschlossen. Dieser Zustand ist in Fig. 5 dargestellt.

Sobald nun im bestimmungsgemäßen Verwendungsfall eine Verdrehbewegung des Korbs 3 stattfindet, entsteht eine Wirbelströmung innerhalb des Bottichs 2, die dafür Sorge trägt, dass die Spülflüssigkeit innenseitig der Bottichwände nach oben gedrückt wird. Hierdurch entsteht im Wasch- und/oder Reinigungsraum 27 des Bottichs 2 ein Unterdruck, so dass bei dann wieder geöffnetem Sperrventil 22 Spülflüssigkeit aus dem Silo 20 in den Bottich 2 nachgesogen wird. Dieses Nachsaugen von Spülflüssigkeit ist in Fig. 5 durch den Pfeil 36 dargestellt.

Sobald ein Spülvorgang beendet ist, wird die Rotationsbewegung des Korbes 3 eingestellt und das Ventil 22 in der Leitung 21 wird wieder geöffnet. Die Spülflüssigkeit kann dann zurück in das Silo 20 strömen, bis wieder Pegelgleichstand besteht.

Die dann noch im Bottich befindliche Restmenge an Spülflüssigkeit ist im Bedarfsfall mittels der Pumpe 24 über die zweite Leitung 23 zurück in das Silo 20 zu führen, was durch den Pfeil 37 dargestellt ist.

Die abgepumpte Spülflüssigkeit wird dem Silo 20 bevorzugterweise von oben aufgegeben, wobei innerhalb des Silos 20 ein Filter 38 angeordnet ist, durch den die von oben aufgegebene Spülflüssigkeit zunächst einmal hindurchströmt, so dass in der Spülflüssigkeit unter Umständen befindliche Schmutzpartikel abgefangen werden können.

Das Silo 20 ist noch an einer Abführleitung 39 angeschlossen, durch die hindurch in Richtung des Pfeils 40 eine Entleerung des Silos 20 stattfinden kann.

Das automatische Einsaugen von Spülflüssigkeit aus dem Silo 20 durch eine Rotation des Korbes 3 erweist sich im Unterschied zur Verwendung einer Pumpe als weniger energieaufwendig. Zudem wird das pumpentypische Problem einer Entmischung einer als Spülflüssigkeit dienenden Alkohol-Wasser-Emulsion vermieden.

**Bezugszeichen**

| | | | |
|---|---|---|---|
| 1 | Wasch- und/oder Reinigungsgerät | 21 | erste Leitung |
| 2 | Bottich | 22 | Sperrventil |
| 3 | Korb | 23 | zweite Leitung |
| 4 | Höhenrichtung | 24 | Pumpe |
| 5 | Korbhochachse | 25 | Trageinheit |
| 6 | Traggestell | 26 | Magazin |
| 7 | Tragrahmen | 27 | Wasch- und/oder Reinigungsraum |
| 8 | Vertikalständer | 28 | Tragrahmen |
| 9 | Schlitten | 29 | Tragstütze |
| 10 | Koppeleinheit | 30 | Haltefortsatz |
| 11 | Beschickungsöffnung | 31 | Balkengestell |
| 12 | Verschlussdeckel | 32 | Balken |
| 13 | Ballondichtung | 33 | Wellenlager |
| 14 | Spindeleinrichtung | 34 | Keilriemen |
| 15 | Motor-Getriebe-Einheit | 35 | Leiterplatte |
| 16 | Welle | 36 | Pfeil |
| 17 | Verbindungsmittel | 37 | Pfeil |
| 18 | Antriebsflansch | 38 | Filter |
| 19 | Motor-Getriebe-Einheit | 39 | Abführleitung |
| 20 | Silo | 40 | Pfeil |

## Patentansprüche

1. Wasch- und/oder Reinigungsgerät für industrielle Bauteile oder Werkstücke, insbesondere Leiterplatten, mit einem einen Wasch- und/oder Reinigungsraum (27) bereitstellenden Bottich (2) und einem der Bauteil- und/oder Werkstückaufnahme dienenden Korb (3), wobei der Korb (3) in Relation zum Bottich (2) in Höhenrichtung (4) verfahrbar und um eine Korbhochachse (5) verdrehbar ausgebildet ist,
**gekennzeichnet durch**
ein Traggestell (6), das einen den Bottich (2) aufnehmenden Tragrahmen (7) aufweist, einen am Traggestell (6) angeordneten Vertikalständer (8) und einen am Vertikalständer (8) angeordneten Schlitten (9), wobei der Schlitten (9) entlang des Vertikalständers (8) in Höhenrichtung verfahrbar ist, wodurch der Korb (3) in den Bottich (2) absenkbar oder aus diesem herausfahrbar ist, und wobei der Schlitten (9) eine Koppeleinheit (10) zur verdrehbaren Anordnung des Korbes (3) bereitstellt, so dass eine Verdrehung des Korbs (3) um eine Korbhochachse (5) realisierbar ist.

2. Wasch- und/oder Reinigungsgerät nach Anspruch 1, **dadurch gekennzeichnet, dass** der Bottich (2) zumindest abschnittsweise kreiszylindrisch ausgebildet ist und koppeleinheitenseitig eine kreisförmig ausgebildete Beschickungsöffnung (11) aufweist.

3. Wasch- und/oder Reinigungsgerät nach Anspruch 2, **dadurch gekennzeichnet, dass** die Koppeleinheit (10) einen mit der Beschickungsöffnung (11) zusammenwirkenden Verschlussdeckel (12) aufweist.

4. Wasch- und/oder Reinigungsgerät nach Anspruch 3,
**dadurch gekennzeichnet, dass**
der Verschlussdeckel (12) bottichseitig eine umlaufende Ballondichtung (13) aufweist.

5. Wasch- und/oder Reinigungsgerät nach Anspruch 3 oder 4, **dadurch gekennzeichnet, dass** der Verschlussdeckel (12) eine Durchgangsöffnung aufweist, durch die hindurch eine verdrehbar am Verschlussdeckel (12) angeordnete Welle (16) geführt ist, die bottichseitig mit einem Verbindungsmittel (17) zur vorzugsweise auswechselbaren Anordnung des Korbes (3) an der Welle (16) und anderendseitig mit einem in Wirkverbindung mit einer Motor-Getriebe-Einheit (19) stehenden Antriebsflansch (18) ausgerüstet ist.

6. Wasch- und/oder Reinigungsgerät nach Anspruch 5, **dadurch gekennzeichnet, dass** die Motor-Getriebe-Einheit (19) der Koppeleinheit (10) gegenüberliegend am Schlitten (9) angeordnet ist.

7. Wasch- und/oder Reinigungsgerät nach einem der vorhergehenden Ansprüche, **dadurch gekennzeichnet, dass** sich der Schlitten (9) unter Zwischenordnung einer Spindeleinrichtung (14) am Vertikalständer (8) abstützt, wobei die Spindeleinrichtung (14) einen stationär am Vertikalständer (8) oder am Traggestell (6) angeordnete Motor-Getriebe-Einheit (15) aufweist.

8. Wasch- und/oder Reinigungsgerät nach einem der vorhergehenden Ansprüche, **dadurch gekennzeichnet, dass** der Bottich (2) zumindest abschnittsweise doppelwandig ausgebildet ist und ein Innenteil und ein Außenteil aufweist, wobei das Innenteil unter Belassung eines Spaltraums innerhalb des Außenteils angeordnet ist.

9. Wasch- und/oder Reinigungsgerät nach einem der vorhergehenden Ansprüche 1 bis 7, **dadurch gekennzeichnet, dass** der Bottich (2) beschickungsöffnungsseitig mit einem die Beschickungsöffnung (11) umlaufend umgebenden Ringkanal ausgerüstet ist.

10. Wasch- und/oder Reinigungsgerät nach einem der vorhergehenden Ansprüche, **gekennzeichnet durch** ein separat zum Bottich (2) ausgebildetes Silo (20) zur Bevorratung von Wasch- und/oder Reinigungsflüssigkeit, wobei der Bottich (2) und das Silo (20) mittels einer ersten Leitung (21) in strömungstechnischer Verbindung stehen, wobei die erste Leitung (21) mit Bezug auf die Höhenrichtung (4) des Bottichs (2) in einen unteren Bereich des Bottichs (2) und mit Bezug auf die Höhenrichtung (4) des Silos (20) in einen unteren Bereich des Silos (20) einmündet.

11. Wasch- und/oder Reinigungsgerät nach Anspruch 10, **gekennzeichnet durch** ein Sperrventil (22) mittels dem die erste Leitung (21) sperrbar ist.

12. Wasch- und/oder Reinigungsgerät nach einem der vorhergehenden Ansprüche, **dadurch gekennzeichnet, dass** der Bottich (2) und das Silo (20) mittels einer zweiten Leitung (23) in strömungstechnischer Verbindung stehen, wobei die zweite Leitung (23) mit Bezug auf die Höhenrichtung (4) des Bottichs (2) in einen unteren Bereich des Bottichs (2) und mit Bezug auf die Höhenrichtung (4) des Silos (20) in einen oberen Bereich des Silos (20) einmündet.

13. Wasch- und/oder Reinigungsgerät nach Anspruch 12, **dadurch gekennzeichnet, dass** in die zweite Leitung (23) eine Pumpe (24) integriert ist.

14. Wasch- und/oder Reinigungsgerät nach einem der vorhergehenden Ansprüche, **dadurch gekennzeichnet, dass** der Korb (3) als Trageinheit (25) mit auswechselbar davon aufgenommenen Magazinen (26) zu beabstandeten Anordnung von Bauteilen und/oder Werkstücken, insbesondere Leiterplatten ausgebildet ist.

## Claims

1. Washing and/or cleaning apparatus for industrial components or workpieces, in particular printed circuit boards, comprising a vat (2) providing a washing and/or cleaning chamber (27) and a basket (3) serving to receive the component and/or workpiece, the basket (3) being designed such that it can be moved in the height direction (4) in relation to the tub (2) and can be rotated about a basket vertical axis (5),
**characterized by**
a supporting structure (6), which has a supporting frame (7) accommodating the vat (2), a vertical post (8) arranged on the supporting structure (6), and a carriage (9) arranged on the vertical post (8), the carriage (9) being movable in the height direction along the vertical post (8) whereby the basket (3) can be lowered into or moved out of the vat (2) and the carriage (9) providing a coupling unit (10) for the rotatable arrangement of the basket (3) so that a rotation of the basket (3) about a basket vertical axis (5) can be performed.

2. Washing and/or cleaning apparatus according to claim 1, **characterized in that** the vat (2) is of circular-cylindrical design, at least in sections, and has a circularly designed loading opening (11) on the coupling unit side.

3. Washing and/or cleaning apparatus according to claim 2, **characterized in that** the coupling unit (10) has a closure lid (12) cooperating with the loading opening (11).

4. Washing and/or cleaning apparatus according to claim 3, **characterized in that** the closure lid (12) has a circumferential balloon seal (13) on the vat side.

5. Washing and/or cleaning apparatus according to claim 3 or 4, **characterized in that** the closure lid (12) has a through-opening through which a shaft (16) is guided which is arranged rotatably on the closure lid (12) and which is equipped on the vat side with a connecting means (17) for the preferably exchangeable arrangement of the basket (3) on the shaft (16) and on the other end side with a drive flange (18) which is operatively connected to a motor-gear unit (19).

6. Washing and/or cleaning apparatus according to claim 5, **characterized in that** the motor-gear unit (19) is arranged opposite the coupling unit (10) on the carriage (9).

7. Washing and/or cleaning apparatus according to any one of the preceding claims, **characterized in that** the carriage (9) is supported on the vertical post (8) with the interposition of a spindle device (14), the spindle device (14) having a motor-gear unit (15) arranged stationarily on the vertical post (8) or on the supporting structure (6).

8. Washing and/or cleaning apparatus according to any one of the preceding claims, **characterized in that** the vat (2) is double-walled at least in sections and has an inner part and an outer part, the inner part being arranged inside the outer part, leaving a gap space.

9. Washing and/or cleaning apparatus according to any one of the preceding claims 1 to 7, **characterized in that** the vat (2) is equipped on the loading opening side with an annular channel circumferentially surrounding the loading opening (11).

10. Washing and/or cleaning apparatus according to any one of the preceding claims, **characterized by** a silo (20), formed separately from the vat (2), for storing washing and/or cleaning liquid, the vat (2) and the silo (20) being in fluidic connection by means of a first conduit (21), wherein the first conduit (21) opens into a lower region of the vat (2) with respect to the height direction (4) of the vat (2) and into a lower region of the silo (20) with respect to the height direction (4) of the silo (20).

11. Washing and/or cleaning apparatus according to claim 10, **characterized by** a blocking valve (22) by means of which the first conduit (21) can be blocked.

12. Washing and/or cleaning apparatus according to any one of the preceding claims, **characterized in that** the vat (2) and the silo (20) are fluidically connected by means of a second conduit (23), the second conduit (23) opening into a lower region of the vat (2) with respect to the height direction (4) of the vat (2) and into an upper region of the silo (20) with respect to the height direction (4) of the silo (20).

13. Washing and/or cleaning apparatus according to claim 12, **characterized in that** a pump (24) is integrated into the second conduit (23).

14. Washing and/or cleaning apparatus according to any one of the preceding claims, **characterized in that** the basket (3) is designed as a carrying unit (25) with magazines (26) interchangeably received by said unit, for the spaced arrangement of components and/or workpieces, in particular printed circuit boards.

## Revendications

1. Appareil de lavage et/ou de nettoyage pour des composants ou des pièces industriels, en particulier des cartes de circuits imprimés, avec une cuve (2) mettant à disposition un espace de lavage et/ou de nettoyage (27) et un panier (3) servant à la réception des composants et/ou des pièces, le panier (3) étant réalisé de manière à pouvoir être déplacé dans le sens de la hauteur (4) par rapport à la cuve (2) et à pouvoir tourner autour d'un axe vertical de panier (5),
**caractérisé par**
un châssis porteur (6) qui présente un cadre de support (7) recevant la cuve (2), un montant vertical (8) disposé sur le châssis de support (6) et un chariot (9) disposé sur le montant vertical (8), le chariot (9) pouvant être déplacé le long du montant vertical (8) dans le sens de la hauteur, ce qui permet d'abaisser le panier (3) dans la cuve (2) ou de le sortir de celle-ci, et le chariot (9) fournissant une unité de couplage (10) pour l'agencement rotatif du panier (3), de sorte qu'une rotation du panier (3) autour d'un axe vertical de panier (5) est possible.

2. Appareil de lavage et/ou de nettoyage selon la revendication 1, **caractérisé en ce que** la cuve (2) est réalisée au moins par sections en forme de cylindre circulaire et présente du côté de l'unité de couplage une ouverture de chargement (11) réalisée en forme de cercle.

3. Appareil de lavage et/ou de nettoyage selon la revendication 2, **caractérisé en ce que** l'unité d'accouplement (10) présente un couvercle de fermeture (12) coopérant avec l'ouverture de chargement (11).

4. Appareil de lavage et/ou de nettoyage selon la revendication 3, **caractérisé en ce que** le couvercle de fermeture (12) présente, du côté de la cuve, un joint d'étanchéité périphérique (13) en forme de ballon.

5. Appareil de lavage et/ou de nettoyage selon la revendication 3 ou 4, **caractérisé en ce que** le couvercle de fermeture (12) présente une ouverture de passage à travers laquelle est guidé un arbre (16) disposé de manière rotative sur le couvercle de fermeture (12), qui est équipé côté cuve d'un moyen de liaison (17) pour la disposition de préférence interchangeable du panier (3) sur l'arbre (16) et côté autre extrémité d'une bride d'entraînement (18) en liaison active avec une unité moteur-transmission (19).

6. Appareil de lavage et/ou de nettoyage selon la revendication 5, **caractérisé en ce que** l'unité moteur-transmission (19) est disposée sur le chariot (9) en face de l'unité d'accouplement (10).

7. Appareil de lavage et/ou de nettoyage selon l'une des revendications précédentes, **caractérisé en ce que** le chariot (9) s'appuie sur le montant vertical (8) avec interposition d'un dispositif à broche (14), le dispositif à broche (14) présentant une unité moteur-réducteur (15) disposée de manière stationnaire sur le montant vertical (8) ou sur le châssis porteur (6).

8. Appareil de lavage et/ou de nettoyage selon l'une des revendications précédentes, **caractérisé en ce que** la cuve (2) est réalisée au moins par sections à double paroi et présente une partie intérieure et une partie extérieure, la partie intérieure étant disposée à l'intérieur de la partie extérieure en laissant un espace de fente.

9. Appareil de lavage et/ou de nettoyage selon l'une des revendications précédentes 1 à 7, **caractérisé en ce que** la cuve (2) est équipée, du côté de l'ouverture de chargement, d'un canal annulaire entourant l'ouverture de chargement (11) sur tout son pourtour.

10. Appareil de lavage et/ou de nettoyage selon l'une des revendications précédentes, **caractérisé par** un silo (20) réalisé séparément de la cuve (2) pour le stockage de liquide de lavage et/ou de nettoyage, la cuve (2) et le silo (20) étant en liaison fluidique au moyen d'une première conduite (21), la première conduite (21) débouchant, par rapport au sens de la hauteur (4) de la cuve (2), dans une zone inférieure de la cuve (2) et, par rapport au sens de la hauteur (4) du silo (20), dans une zone inférieure du silo (20).

11. Appareil de lavage et/ou de nettoyage selon la revendication 10, **caractérisé par** une vanne d'arrêt (22) au moyen de laquelle la première conduite (21) peut être bloquée.

12. Appareil de lavage et/ou de nettoyage selon l'une des revendications précédentes, **caractérisé en ce que** la cuve (2) et le silo (20) sont en communication fluidique au moyen d'une deuxième conduite (23), la deuxième conduite (23) débouchant dans une zone inférieure de la cuve (82) par rapport au sens de la hauteur (4) de la cuve (2) et dans une zone supérieure du silo (20) par rapport au sens de la hauteur (4) du silo (20).

13. Appareil de lavage et/ou de nettoyage selon la revendication 12, **caractérisé en ce qu'**une pompe (24) est intégrée dans la deuxième conduite (23).

14. Appareil de lavage et/ou de nettoyage selon l'une des revendications précédentes, **caractérisé en ce que** le panier (3) est conçu comme une unité de support (25) avec des magasins (26) reçus de manière interchangeable par celle-ci pour la disposition espacée de composants et/ou de pièces, en particulier de cartes de circuits imprimés.
